(19) Europäisches Patentamt
European Patent Office
Office européen des brevets

(11) EP 2 233 960 A1

(12) EUROPEAN PATENT APPLICATION
published in accordance with Art. 153(4) EPC

(43) Date of publication:
29.09.2010 Bulletin 2010/39

(51) Int Cl.:
G02B 26/08 (2006.01)    G02B 19/00 (2006.01)
G03F 7/20 (2006.01)    H01L 21/027 (2006.01)

(21) Application number: 08861234.6

(22) Date of filing: 04.11.2008

(86) International application number:
PCT/JP2008/069997

(87) International publication number:
WO 2009/078223 (25.06.2009 Gazette 2009/26)

(84) Designated Contracting States:
AT BE BG CH CY CZ DE DK EE ES FI FR GB GR
HR HU IE IS IT LI LT LU LV MC MT NL NO PL PT
RO SE SI SK TR
Designated Extension States:
AL BA MK RS

(30) Priority: 17.12.2007  JP 2007324115

(71) Applicant: Nikon Corporation
Tokyo 100-8331 (JP)

(72) Inventor: TANITSU, Osamu
Tokyo 100-8331 (JP)

(74) Representative: HOFFMANN EITLE
Patent- und Rechtsanwälte
Arabellastrasse 4
81925 München (DE)

(54) SPATIAL LIGHT MODULATING UNIT, ILLUMINATION OPTICAL SYSTEM, ALIGNER, AND DEVICE MANUFACTURING METHOD

(57)    An illumination optical system is able to achieve a desired pupil intensity distribution, for example, while suppressing influence of diffracted light arising from the surroundings of a large number of microscopic mirror elements arranged regularly. The illumination optical system (IL) which illuminates an illumination target surface (M) on the basis of light from a light source (1) is provided with a spatial light modulating unit (3), and a distribution forming optical system (4, 5) which forms a predetermined light intensity distribution on an illumination pupil on the basis of a flux of light having traveled via a spatial light modulator. The spatial light modulating unit (3) is provided with the spatial light modulator (3a) having a plurality of optical elements arrayed two-dimensionally and controlled individually, and an angle varying device which varies a relative angle between a diffracted light generating region to generate diffracted light around each of the optical elements, and incident light to the diffracted light generating region.

**Fig.1**

**Description**

**TECHNICAL FIELD**

The present invention relates to a spatial light modulating unit, an illumination optical system, an exposure apparatus, and a device manufacturing method. More particularly, the present invention relates to an illumination optical system suitably applicable to an exposure apparatus for manufacturing such devices as semiconductor devices, imaging devices, liquid crystal display devices, and thin film magnetic heads by lithography.

**BACKGROUND ART**

In a typical exposure apparatus of this type, a light beam emitted from a light source travels through a fly's eye lens as an optical integrator to form a secondary light source (a predetermined light intensity distribution on an illumination pupil in general) as a substantial surface illuminant consisting of a large number of light sources. The light intensity distribution on the illumination pupil will be referred to hereinafter as a "pupil intensity distribution." The illumination pupil is defined as a position such that an illumination target surface becomes a Fourier transform plane of the illumination pupil by action of an optical system between the illumination pupil and the illumination target surface (a mask or a wafer in the case of the exposure apparatus).

Beams from the secondary light source are condensed by a condenser lens to superposedly illuminate the mask on which a predetermined pattern is formed. Light passing through the mask travels through a projection optical system to be focused on the wafer, whereby the mask pattern is projected (or transferred) onto the wafer to effect exposure thereof. Since the pattern formed on the mask is a highly integrated one, an even illuminance distribution must be obtained on the wafer in order to accurately transfer this microscopic pattern onto the wafer.

There is a hitherto proposed illumination optical system capable of continuously changing the pupil intensity distribution (and, in turn, an illumination condition) without use of a zoom optical system (cf. Patent Document 1). In the illumination optical system disclosed in Patent Document 1, using a movable multi-mirror composed of a large number of microscopic mirror elements which are arranged in an array form and an inclination angle and inclination direction of each of which are individually driven and controlled, an incident beam is divided in microscopic units by respective reflecting surfaces to be deflected thereby, so as to convert a cross section of the incident beam into a desired shape or desired size and, in turn, so as to realize a desired pupil intensity distribution.

Patent Document 1: Japanese Patent Application Laid-open No. 2002-353105

**DISCLOSURE OF THE INVENTION**

**Problem to be Solved by the Invention**

Since the illumination optical system described in Patent Document 1 uses the large number of microscopic mirror elements whose postures are individually controlled, degrees of freedom are high about change in shape and size of the pupil intensity distribution. However, diffracted light beams generated from a grid-like mirror frame lying between the large number of mirror elements arranged regularly form diffraction interference fringes on the illumination pupil plane and in some cases it is difficult to form a desired pupil intensity distribution because of influence of the diffraction interference fringes.

The present invention has been accomplished in view of the foregoing problem and it is an object of the present invention to provide an illumination optical system capable of achieving a desired pupil intensity distribution, for example, while suppressing the influence of diffracted light beams arising from the surroundings of the large number of regularly-arranged mirror elements. It is another object to provide an exposure apparatus capable of performing excellent exposure under an appropriate illumination condition, using the illumination optical system achieving the desired pupil intensity distribution while suppressing the influence of diffracted light beams.

**Means for Solving the Problem**

In order to solve the problem, a first aspect of the present invention provides a spatial light modulating unit comprising:

a spatial light modulator having a plurality of optical elements arrayed two-dimensionally and controlled individually; and
angle varying means which varies a relative angle between a diffracted light generating region to generate diffracted light around each of the plurality of optical elements, and incident light to the diffracted light generating region.

A second aspect of the present invention provides an illumination optical system which illuminates an illumination target surface on the basis of light from a light source, the illumination optical system comprising:

the spatial light modulating unit of the first aspect; and
a distribution forming optical system which forms a predetermined light intensity distribution on an illumination pupil of the illumination optical system, based on a flux of light having traveled via the spatial light modulator.

A third aspect of the present invention provides an illumination optical system which illuminates an illumination target surface on the basis of light from a light source, the illumination optical system comprising:

a spatial light modulator having a plurality of optical elements arrayed two-dimensionally and controlled individually, and a diffracted light generating region which generates diffracted light around each of the plurality of optical elements; and
a light-guiding optical system which guides the light from the light source to the spatial light modulator,
wherein a posture of at least one of the spatial light modulator and at least a part of the light-guiding optical system is variable in order to vary a relative angle between the diffracted light generating region and incident light to the diffracted light generating region.

A fourth aspect of the present invention provides an exposure apparatus comprising the illumination optical system of the second aspect or the third aspect for illuminating a predetermined pattern, wherein the predetermined pattern is transferred onto a photosensitive substrate to effect exposure thereof.
A fifth aspect of the present invention provides a device manufacturing method comprising:

an exposure step of transferring the predetermined pattern onto the photosensitive substrate to effect exposure thereof, using the exposure apparatus of the fourth aspect;
a development step of developing the photosensitive substrate on which the predetermined pattern is transferred, to form a mask layer of a shape corresponding to the predetermined pattern, on a surface of the photosensitive substrate; and
a processing step of processing the surface of the photosensitive substrate through the mask layer.

**Effects of the Invention**

The illumination optical system of the present invention is configured to appropriately vary the relative angle between the diffracted light generating region to generate diffracted light around each of the plurality of optical elements of the spatial light modulator, and the incident light to the diffracted light generating region, according to the lapse of time. As a result, the position of diffraction interference fringes formed on the illumination pupil varies according to the lapse of time, whereby the influence of diffraction interference fringes on the pupil intensity distribution is reduced by a so-called temporal averaging effect.
In this manner, the illumination optical system of the present invention is able to achieve a desired pupil intensity distribution, for example, while suppressing the influence of diffracted light arising from the diffracted light generating region around the large number of microscopic mirror elements arranged regularly. The exposure apparatus of the present invention is able to perform excellent exposure under an appropriate illumination condition achieved according to a pattern characteristic of the mask, using the illumination optical system achieving the desired pupil intensity distribution while suppressing the influence of diffracted light, and, in turn, to manufacture excellent devices.

**BRIEF DESCRIPTION OF THE DRAWINGS**

Fig. 1 is a drawing schematically showing a configuration of an exposure apparatus according to an embodiment of the present invention.
Fig. 2 is a drawing schematically showing configurations of a spatial light modulating unit and a zoom optical system.
Fig. 3 is a partial perspective view of a spatial light modulator incorporated in the spatial light modulating unit.
Fig. 4 is a sectional view schematically showing a typical configuration of the spatial light modulator.
Fig. 5 is a drawing for explaining a first technique of the embodiment.
Fig. 6 is a drawing for explaining a second technique of the embodiment.
Fig. 7 is a drawing for explaining a third technique of the embodiment.
Fig. 8 is a drawing schematically showing a first configuration example of a prism member having the same function as a K prism in the embodiment.

Fig. 9 is a drawing schematically showing a second configuration example of a prism member having the same function as the K prism in the embodiment.

Fig. 10 is a drawing schematically showing a configuration example of an assembled optical member having the same function as the K prism in the embodiment.

Fig. 11 is a flowchart showing manufacturing steps of semiconductor devices.

Fig. 12 is a flowchart showing manufacturing steps of a liquid crystal device such as a liquid crystal display device.

**List of Preference Symbols**

| 1 | light source |
| 2 | beam sending unit |
| 3 | spatial light modulating unit |
| 3a | spatial light modulator |
| 3b | K prism |
| 3c | drive unit |
| 4 | zoom optical system |
| 5 | fly's eye lens |
| 6 | condenser optical system |
| 7 | illumination field stop (mask blind) |
| 8 | field stop imaging optical system |
| IL | illumination optical system |
| CR | control unit |
| M | mask |
| PL | projection optical system |
| W | wafer |

**BEST MODES FOR CARRYING OUT THE INVENTION**

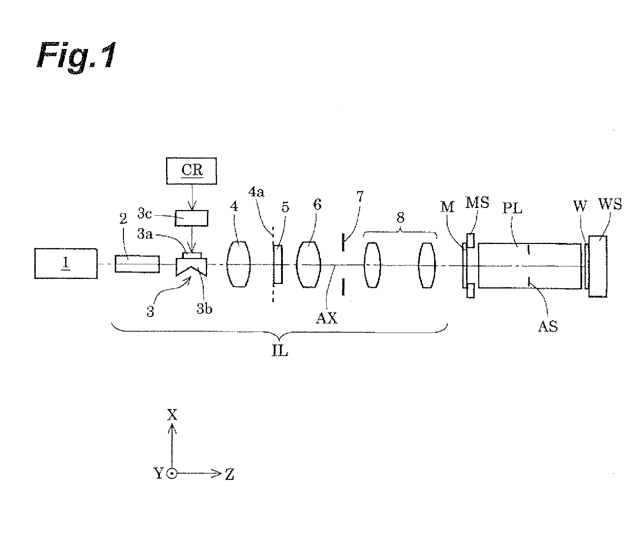

Embodiments of the present invention will be described on the basis of the accompanying drawings. Fig. 1 is a drawing schematically showing a configuration of an exposure apparatus according to an embodiment of the present invention. In Fig. 1, the Z-axis is set along a direction of a normal to a wafer W being a photosensitive substrate, the X-axis is set along a direction parallel to the plane of Fig. 1 in an exposed surface of the wafer W, and the Y-axis is set along a direction perpendicular to the plane of Fig. 1 in the exposed surface of the wafer W.

Referring to Fig. 1, the exposure apparatus of the present embodiment has an illumination optical system IL including a spatial light modulating unit 3, a mask stage MS supporting a mask M, a projection optical system PL, and a wafer stage WS supporting the wafer W, along the optical axis AX of the apparatus. The exposure apparatus of the present embodiment is configured to illuminate the mask M with illumination light (exposure light) from a light source 1 through the illumination optical system IL. Light transmitted by the mask M travels through the projection optical system PL to form an image of a pattern of the mask M on the wafer W.

The illumination optical system IL for illuminating a pattern surface (illumination target surface) of the mask M on the basis of the light from the light source 1 implements modified illumination such as multi-polar illumination (dipolar illumination, quadrupolar illumination, or the like) or annular illumination by action of the spatial light modulating unit 3. The illumination optical system IL has, in order from the light source 1 side along the optical axis AX, a beam sending unit 2, the spatial light modulating unit 3, a zoom optical system 4, a fly's eye lens 5, a condenser optical system 6, an illumination field stop (mask blind) 7, and a field stop imaging optical system 8.

The spatial light modulating unit 3 forms a desired light intensity distribution (pupil intensity distribution) in its far field region (Fraunhofer diffraction region), based on the light from the light source 1 through the beam sending unit 2. The configuration and action of the spatial light modulating unit 3 will be described later. The beam sending unit 2 has functions to guide an incident beam from the light source 1 to the spatial light modulating unit 3 while converting the incident beam into a beam having a cross section of an appropriate size and shape, and to actively correct variation in position and variation in angle of the beam incident to the spatial light modulating unit 3. The zoom optical system 4 condenses the light from the spatial light modulating unit 3 and guides the condensed light to the fly's eye lens 5.

The fly's eye lens 5 is an optical integrator of a wavefront division type consisting of a large number of lens elements arrayed densely, for example. The fly's eye lens 5 divides the wavefront of the incident beam to form a secondary light source (substantial surface illuminant) consisting of light source images as many as the lens elements, on its rear focal plane. An entrance plane of the fly's eye lens 5 is arranged at or near the rear focus position of the zoom optical system 4. The fly's eye lens 5 to be used herein can be, for example, a cylindrical micro fly's eye lens. The configuration and action of the cylindrical micro fly's eye lens are disclosed, for example, in U.S. Pat. No. 6,913,373. It is also possible to use, for example, the micro fly's eye lens disclosed in U.S. Pat. No. 6,741,394, as the fly's eye lens. The teachings of U.S. Pat. Nos. 6,913,373 and 6,741,394 are incorporated herein by reference.

In the present embodiment, the mask M placed on the illumination target surface of the illumination optical system IL is illuminated by Köhler illumination using the secondary light source formed by the fly's eye lens 5, as a light source. For this, the position where the secondary light source is formed is optically conjugate with a position of an aperture stop AS of the projection optical system PL and a plane where the secondary light source is formed can be called an illumination pupil plane of the illumination optical system IL. Typically, the illumination target surface (the plane where the mask M is placed, or the plane where the wafer W is placed if the illumination optical system is considered to include the projection optical system PL) becomes an optical Fourier transform plane with respect to the illumination pupil plane.

The pupil intensity distribution is a light intensity distribution (luminance distribution) on the illumination pupil plane of the illumination optical system IL or on a plane conjugate with the illumination pupil plane. When the number of divisions of the wavefront by the fly's eye lens 5 is relatively large, an overall light intensity distribution formed on the entrance plane of the fly's eye lens 5 demonstrates a high correlation with an overall light intensity distribution (pupil intensity distribution) of the entire secondary light source. For this reason, the light intensity distributions on the entrance plane of the fly's eye lens 5 and on a plane optically conjugate with the entrance plane can also be called pupil intensity distributions.

The condenser optical system 6 condenses the light emitted from the fly's eye lens 5 to illuminate the illumination field stop 7 in a superimposed manner. Light from the illumination field stop 7 travels through the field stop imaging optical system 8 to form an illumination region being an image of an aperture of the illumination field stop 7, in at least a part of the pattern forming region on the mask M. Fig. 1 is depicted without installation of path bending mirrors for bending the optical axis (optical path eventually), but it should be noted that it is optional to arrange an appropriate number of path bending mirrors in the illumination optical path as needed.

The mask M is mounted along the XY plane (e.g., a horizontal plane) on the mask stage MS and the wafer W is mounted along the XY plane on the wafer stage WS. The projection optical system PL forms an image of the pattern of the mask M on the exposed surface (projection surface) of the wafer W, based on light from the illumination region formed on the pattern surface of the mask M by the illumination optical system IL. In this manner, the pattern of the mask M is successively transferred onto each of exposure regions on the wafer W by carrying out full-shot exposure or scan exposure while two-dimensionally driving and controlling the wafer stage WS in the plane (XY plane) perpendicular to the optical axis AX of the projection optical system PL and, therefore, while two-dimensionally driving and controlling the wafer W.

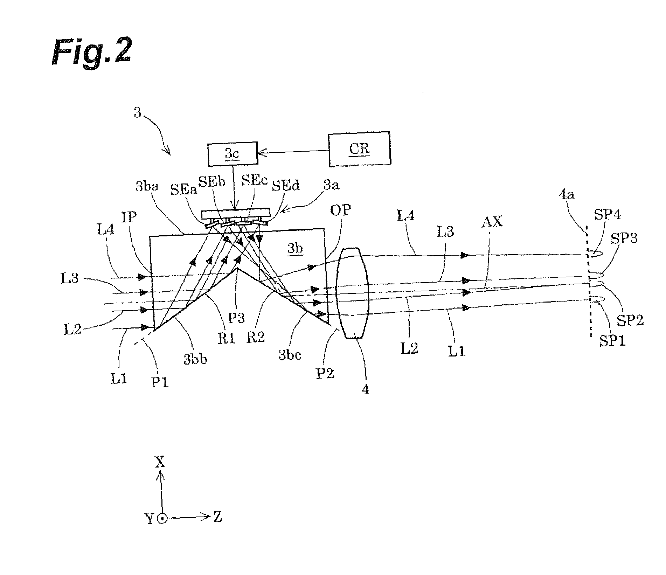

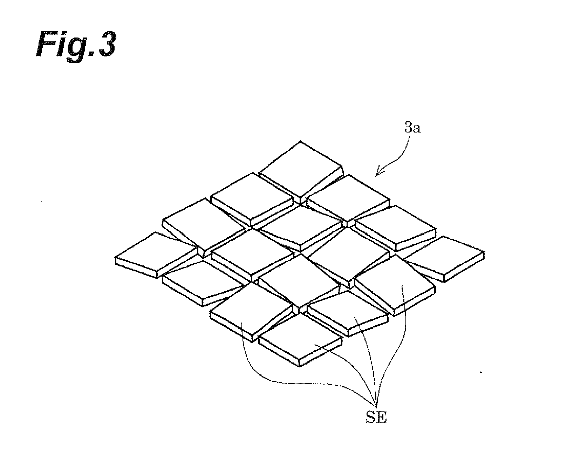

The configuration and action of the spatial light modulating unit 3 will be described below with reference to Figs. 2 and 3. Fig. 2 is a drawing schematically showing configurations of the spatial light modulating unit 3 and the zoom optical system 4. Fig. 3 is a partial perspective view of spatial light modulator 3 a incorporated in the spatial light modulating unit 3. The spatial light modulating unit 3, as shown in Fig. 2, has a prism 3b made of an optical material, e.g., like fluorite, and a spatial light modulator 3a of a reflection type installed in proximity to a side face 3ba of the prism 3b parallel to the YZ plane. The optical material making up the prism 3b does not have to be limited to fluorite, but may be quartz or any other optical material depending, for example, upon the wavelength of the light supplied from the light source 1.

The prism 3b has a form obtained by replacing one side face (side face opposed to the side face 3ba to which the spatial light modulator 3a is installed in proximity) of a rectangular parallelepiped with side faces 3bb and 3bc of a V shaped indentation, and is also called a K prism because of its cross-sectional shape along the XZ plane. The side faces 3bb and 3bc of the V-shaped indentation in the prism 3b are defined by two planes P1 and P2 intersecting at an obtuse angle. The two planes P1 and P2 both are perpendicular to the XZ plane and form a V-shape along the XZ plane.

Internal surfaces of the two side faces 3bb and 3bc in contact with each other on an intersecting line (straight line extending in the Y-direction) P3 between the two planes P1 and P2 function as reflecting surfaces R1 and R2. Namely, the reflecting surface R1 is located on the plane P1, the reflecting surface R2 is located on the plane P2, and the angle between the reflecting surfaces R1 and R2 is an obtuse angle. As an example, the angle between the reflecting surfaces R1 and R2 can be 120°, the angle between an input plane IP of the prism 3b normal to the optical axis AX, and the reflecting surface R1 60°, and the angle between an output plane OP of the prism 3b normal to the optical axis AX, and the reflecting surface R2 60°.

The prism 3b is arranged so that the side face 3ba, to which the spatial light modulator 3a is installed in proximity, is parallel to the optical axis AX and so that the reflecting surface R1 is located on the light source 1 side (upstream in the exposure apparatus: on the left in Fig. 2) and the reflecting surface R2 on the fly's eye lens 5 side (downstream in the exposure apparatus: on the right in Fig. 2). More specifically, the reflecting surface R1 is inclined with respect to the optical axis AX and the reflecting surface R2 is inclined with respect to the optical axis AX in symmetry with the reflecting surface R1 with respect to a plane passing the tangent line P3 and being parallel to the XY plane. The side face 3ba of the prism 3b is an optical surface opposed to the plane where a plurality of mirror elements SE of the spatial light modulator 3a are arrayed, as described below.

The reflecting surface R1 of the prism 3b reflects light incident thereto through the input plane IP, toward the spatial light modulator 3 a. The spatial light modulator 3a is arranged in the optical path between the reflecting surface R1 and the reflecting surface R2 and reflects the light incident thereto via the reflecting surface R1. The reflecting surface R2 of the prism 3b reflects the light incident thereto via the spatial light modulator 3a and guides the light through the output plane OP to the zoom optical system 4. Fig. 2 shows an example in which the prism 3b is integrally formed of a single optical block, but the prism 3b may also be constructed of a plurality of optical blocks as described below.

The spatial light modulator 3a imparts spatial modulations according to positions of incidence of incident rays, to the rays incident thereto via the reflecting surface R1 and outputs the spatially modulated rays. The spatial light modulator 3a, as shown in Fig. 3, has a plurality of microscopic mirror elements (optical elements) SE arrayed two-dimensionally. For simplicity of description and illustration, Figs. 2 and 3 show a configuration example wherein the spatial light modulator 3a has $4\times4=16$ mirror elements SE, but in fact the spatial light modulator 3a has many more mirror elements SE than 16 elements.

With reference to Fig. 2, among a group of rays incident along a direction parallel to the optical axis AN into the spatial light modulating unit 3, a ray L1 is incident to a mirror element SEa out of the plurality of mirror elements SE, and a ray L2 is incident to a mirror element SEb different from the mirror element SEa. Similarly, a ray L3 is incident to a mirror element SEc different from the mirror elements SEa, SEb, and a ray L4 is incident to a mirror element SEd different from the mirror elements SEa-SEc. The mirror elements SEa-SEd impart respective spatial modulations set according to their positions, to the rays L1-L4.

The spatial light modulating unit 3 is configured in a configuration wherein in a standard state in which reflecting surfaces of all the mirror elements SE of the spatial light modulator 3a are set in parallel with the YZ plane, rays incident along the direction parallel to the optical axis AX to the reflecting surface R1 travel via the spatial light modulator 3a and thereafter are reflected to the direction parallel to the optical axis AX by the reflecting surface R2. The spatial light modulating unit 3 is also configured so that an air equivalent length from the input plane IP of the prism 3b to the output plane OP via the mirror elements SEa-SEd is equal to an air equivalent length from a position corresponding to the input plane IP to a position corresponding to the output plane OP without the prism 3b in the optical path. The air equivalent length herein is an optical path length in air with the refractive index of 1 reduced from the optical path length in the optical system, and an air equivalent length in a medium with the refractive index of n is a value obtained by multiplying the optical path length by 1/n.

The spatial light modulator 3a is arranged at or near the front focus position of the zoom optical system 4. The rays reflected and given a predetermined angle distribution by the plurality of mirror elements SEa-SEd of the spatial light modulator 3a form predetermined light intensity distributions SP1-SP4 on the rear focal plane 4a of the zoom optical system 4. Namely, the zoom optical system 4 converts angles given to the output rays by the plurality of mirror elements SEa-SEd of the spatial light modulator 3a, into positions on the plane 4a being the far field region (Fraunhofer diffraction region) of the spatial light modulator 3a.

Referring again to Fig. 1, the entrance plane of the fly's eye lens 5 is positioned at or near the rear focal plane 4a of the zoom optical system 4 functioning as a condensing optical system. Therefore, the light intensity distribution (luminance distribution) of the secondary light source formed by the fly's eye lens 5 becomes a distribution according to the light intensity distributions SP1-SP4 formed by the spatial light modulator 3a and the zoom optical system 4. The spatial light modulator 3a, as shown in Fig. 3, is a movable multi-mirror including the mirror elements SE which are a large number of microscopic reflecting elements arrayed regularly and two-dimensionally along one plane in a state in which their reflecting surfaces of a planar shape are respective top faces.

Each mirror element SE is movable and an inclination of its reflecting surface, i.e., an inclination angle and inclination direction of the reflecting surface, is independently controlled by action of a drive unit 3c (which is not shown in Fig. 3) which operates in accordance with a command from a control unit CR (not shown in Fig. 3). Each mirror element SE is continuously or discretely rotatable by a desired rotation angle around axes of rotation along two mutually orthogonal directions (Y-direction and Z-direction) which are two directions parallel to the reflecting surface. Namely, the inclination of the reflecting surface of each mirror element SE can be two-dimensionally controlled.

When the reflecting surface of each mirror element SE is discretely rotated, a preferred control method is to switch the rotation angle among a plurality of states (e.g., ..., -2.5°, -2.0°,...0°, +0.5°...+2.5°,...). Fig. 3 shows the mirror elements SE with the contour of a square shape, but the contour of the mirror elements SE is not limited to the square shape. However, in terms of light utilization efficiency, it is also possible to adopt a shape enabling an array with a small clearance between the mirror elements SE (shape enabling closest packing). Furthermore, in terms of light utilization efficiency, it is also possible to adopt a configuration wherein the clearance between two adjacent element mirrors SE is reduced to the minimum necessary.

The present embodiment uses as the spatial light modulator 3 a, a spatial light modulator which continuously (or discretely) varies each of orientations of the mirror elements SE arrayed two-dimensionally. The spatial light modulator of this type applicable herein can be selected, for example, from the spatial light modulators disclosed in Published Japanese Translation of PCT Application No. 10-503300 and European Patent Published Application No. 779530 corresponding thereto, Japanese Patent Application Laid-open No. 2004-78136 and U.S. Pat. No. 6,900,915 corresponding thereto, Published Japanese Translation of PCT Application No. 2006-524349 and U.S. Pat. No. 7,095,546 corresponding thereto, and Japanese Patent Application Laid-open No. 2006-113437. The teachings of European Patent Published Application No. 779530, U.S. Pat. No. 6,900,915, and U.S. Pat. No. 7,095,546 are incorporated herein by reference.

In the spatial light modulator 3a, postures of the respective mirror elements SE each are varied and the mirror elements SE are set in respective predetermined orientations, by action of the drive unit 3c operating in accordance with a control signal from the control unit CR. Rays reflected at respective predetermined angles by the plurality of mirror elements SE of the spatial light modulator 3a travel through the zoom optical system 4 to form a light intensity distribution (pupil intensity distribution) of a multi-polar shape (dipolar shape, quadrupolar shape, or the like), annular shape, or the like on the illumination pupil at or near the rear focus position of the fly's eye lens 5. This pupil intensity distribution similarly (isotropically) varies by action of the zoom optical system 4.

Namely, the zoom optical system 4 and the fly's eye lens 5 constitute a distribution forming optical system which forms a predetermined light intensity distribution on the illumination pupil of the illumination optical system IL, based on a flux of light having traveled via the spatial light modulator 3a in the spatial light modulating unit 3. Furthermore, light intensity distributions corresponding to the pupil intensity distribution are also formed at other illumination pupil positions optically conjugate with the illumination pupil at or near the rear focus position of the fly's eye lens 5, i.e., at a pupil position of the field stop imaging optical system 8 and at a pupil position of the projection optical system PL (position of the aperture stop AS).

For the exposure apparatus to highly accurately and faithfully transfer the pattern of the mask M onto the wafer W, it is important, for example, to perform exposure under an appropriate illumination condition according to a pattern characteristic of the mask M. Since the present embodiment adopts the spatial light modulating unit 3 with the spatial light modulator 3a wherein the postures of the mirror elements SE each are individually varied, the pupil intensity distribution formed by action of the spatial light modulator 3a can be freely and quickly varied.

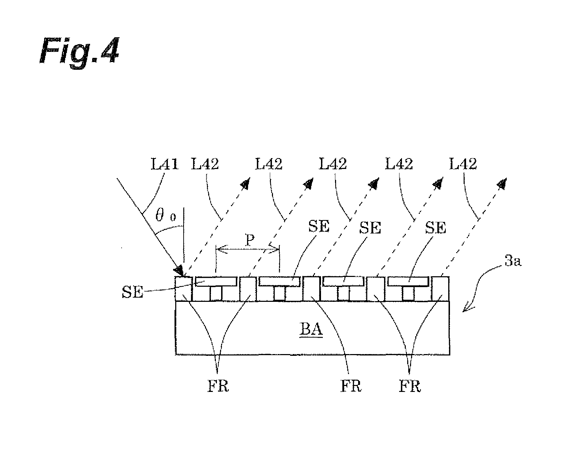

In the illumination optical system IL of the present embodiment using the spatial light modulator 3a, however, diffraction interference fringes are formed on the illumination pupil plane by diffracted light arising from a top surface of a grid-like mirror frame lying between the plurality of mirror elements SE arranged regularly, as described below. As a result of this, it is sometimes difficult to form a desired pupil intensity distribution because of influence of the diffraction interference fringes. The generation and influence of diffraction interference fringes will be described below with reference to Fig. 4.

Fig. 4 is a sectional view schematically showing a typical configuration of the spatial light modulator. In the typical configuration example of the spatial light modulator 3a, as shown in Fig. 4, a plurality of mirror elements SE are mounted through a hinge (not shown) on a base BA and a mirror frame FR is provided between the plurality of mirror elements SE. The mirror elements SE each have a small reflecting surface, for example, of a square shape and are arranged regularly. Therefore, the top surface (upper surface in Fig. 4) of the mirror frame FR disposed between the mirror elements SE has a grid-like form as a whole, for example.

In this case, when a ray L41 (indicated by a solid line in the drawing) is incident to the small top surface of the mirror frame FR arranged regularly, specularly diffracted rays L42 (indicated by dashed lines in the drawing) appear from the top surface of the mirror frame FR. For simplicity of the drawing, Fig. 4 shows only the incident ray 41 to the top surface of the mirror frame FR at the left end, but the incident ray 41 is actually incident at the same angle to the whole of the spatial light modulator 3a. At this time, a relation represented by Eq (1) below holds among the pitch P of the mirror elements SE, the wavelength $\lambda$ of the light, an angle of incidence $\theta_0$ of the ray L41 to the top surface of the mirror frame FR, and an angle of diffraction $\theta_N$ of Nth-order diffracted light from the top surface of the mirror frame FR.

$$\sin\theta_N - \sin\theta_0 = N \times \lambda/P \qquad (1)$$

As described above, the illumination optical system IL of the present embodiment obtains the pupil intensity distribution consisting of a primary light intensity distribution formed on the illumination pupil by the required light reflected by the plurality of mirror elements SE, and a light intensity distribution (diffraction interference fringes) formed on the illumination pupil by the diffracted light as unwanted light arising from the top surface of the mirror frame FR. In other words, without any special countermeasures, the illumination optical system IL of the present embodiment is unable to obtain a desired pupil intensity distribution by the degree of the diffraction interference fringes formed by the diffracted light from the top surface of the mirror frame FR.

In the configuration example shown in Fig. 4, the mirror frame FR is provided between the plurality of mirror elements SE and the top surface of the mirror frame FR constitutes a diffracted light generating region to generate diffracted light around each of the mirror elements SE. Even in a configuration example without the mirror frame, light travels through the fine grid-like clearances between the mirror elements SE to reach the surface of the base to generate diffracted light and to form diffraction interference fringes on the illumination pupil eventually. In this case, the grid-like base surface region corresponding to the fine clearances between the mirror elements SE constitutes a diffracted light generating region to generate diffracted light around each of the mirror elements SE.

In the present embodiment, a relative angle between the diffracted light generating region (the top surface of the mirror frame FR in Fig. 4) to generate the diffracted light around each mirror element SE of the spatial light modulator 3a and the incident light (light L41 in Fig. 4) to the diffracted light generating region is appropriately varied according to the lapse of time. As a result, in the present embodiment the position of the diffraction interference fringes formed on the illumination pupil varies according to the lapse of time, and the influence of the diffraction interference fringes on the pupil intensity distribution is reduced by a so-called temporal averaging effect, so as to enable achievement of the desired pupil intensity distribution eventually.

In this manner, the illumination optical system IL of the present embodiment is able to achieve the desired pupil intensity distribution while suppressing the influence of the diffracted light arising from the diffracted light generating region around the large number of microscopic mirror elements SE arranged regularly in the spatial light modulator 3a. The exposure apparatus (3-WS) of the present embodiment is able to perform excellent exposure under an appropriate illumination condition achieved according to the pattern characteristic of the mask M, using the illumination optical system IL achieving the desired pupil intensity distribution while suppressing the influence of diffracted light.

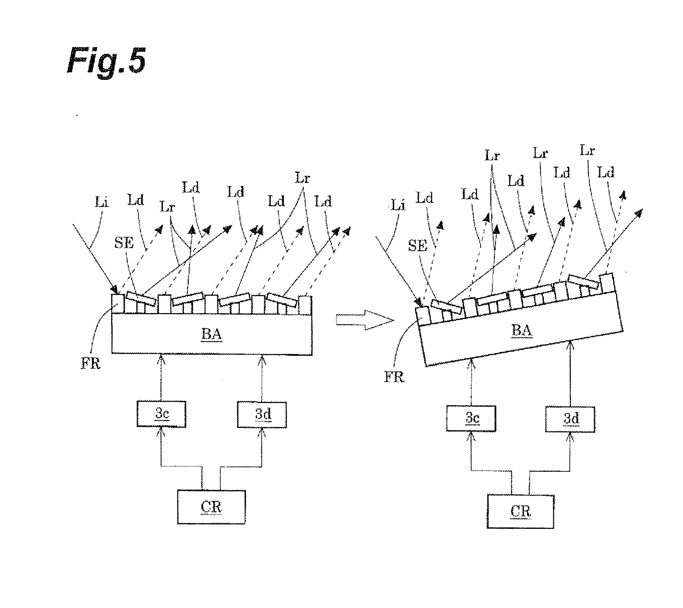

Specifically, a first technique of the present embodiment is, as shown in Fig. 5, to vary the posture of the entire spatial light modulator 3a and therefore the posture of the diffracted light generating region according to the lapse of time, by action of a first varying unit 3d operating in accordance with a control signal from the control unit CR. The first varying unit 3d applicable herein can be, for example, a drive device (e.g., a piezoelectric device) mounted, for example, in a region where no effective beam passes between the spatial light modulator 3a and the side face 3ba of the prism 3b.

With variation in the posture of the entire spatial light modulator 3a, the direction of the top surface of the mirror frame FR, the direction of the surface of the base BA, and the direction of the reflecting surface of each mirror element SE also vary similarly. On the other hand, the direction of the incident light Li to the spatial light modulator 3a does not vary even with variation in the posture of the entire spatial light modulator 3a. For simplicity of the drawing, Fig. 5 shows only the incident light Li to the top surface of the mirror frame FR at the left end, but in fact the incident light Li is also incident at the same angle to the whole of the spatial light modulator 3a. Therefore, the direction of the diffracted light Ld as unwanted light arising from the diffracted light generating region on the top surface of the mirror frame FR (or the surface of the base BA) varies with variation in the posture of the entire spatial light modulator 3a.

Similarly, unless the posture of each mirror element SE is actively varied by the drive unit 3c, the direction of the reflected light Lr from each mirror element SE also varies with variation in the posture of the entire spatial light modulator 3a. As a result, the position of the diffraction interference fringes formed on the illumination pupil by the diffracted light Ld from the diffracted light generating region varies according to the lapse of time and the position of the light intensity distribution (primarily required pupil intensity distribution) formed on the illumination pupil by the reflected light Lr from each mirror element SE also varies according to the lapse of time.

When the exposure apparatus of the present embodiment uses a laser light source to supply pulsed light, for example, like an excimer laser light source, the required averaging effect by the variation in the position of the diffraction interference fringes on the illumination pupil may be achieved by round-trip inclination of the entire spatial light modulator 3a, for example, across a required angular range during irradiation of light in a pulse count necessary for a single full-shot exposure, i.e., an exposure pulse count. Another applicable method may be to perform one-way inclination of the entire spatial light modulator 3a, for example, across a required angular range during irradiation of light in the exposure pulse count.

In application of the scan exposure, the averaging effect can be achieved by round-trip inclination of the entire spatial light modulator 3a, for example, across a required angular range during irradiation of light in a minimum exposure pulse count Nmin to be irradiated per point on the wafer W, or by one-way inclination of the entire spatial light modulator 3a, for example, across a required angular range during irradiation of light in the minimum exposure pulse count Nmin. The minimum exposure pulse count Nmin is the number of pulses as the minimum necessary for reproduction of exposure dose control, and is determined, for example, based on a ratio $\delta H/H$, a ratio of dispersion $\delta H$ (value of $3\delta$) of pulse energy as a preliminarily measured device constant, to average pulse energy density H. Namely, the minimum exposure pulse count Nmin is the number of pulses necessary for controlling the dispersion of integral exposure dose within a predetermined tolerance.

Accordingly, the illumination light IL is applied typically by N pulses to each point in a scanning exposure range (shot area) on the wafer W If $N \geq Nmin$, integral light quantities at respective points in the scanning exposure range become approximately equal and an integral light quantity distribution in the scanning exposure range becomes approximately uniform, particularly, even in a non-scan direction; namely, nonuniformity in integral light quantities is controlled within a predetermined tolerance. However, if the integral light quantity distribution in the non-scan direction is not averaged even by applying the illumination light IL of N pulses satisfying $N \geq Nmin$, to each point in the scanning exposure range, the pulse count may be that necessary for controlling the dispersion of integral light quantity within the predetermined tolerance, and the minimum exposure pulse count Nmin may be determined also taking account of the pulse count necessary for averaging the integral light quantity distribution in the non-scan direction.

As described above, the position of the light intensity distribution formed on the illumination pupil by the reflected light Lr on each mirror element SE also varies in synchronism with the variation in the posture of the entire spatial light modulator 3a, but adjustment of the posture of each mirror element SE by the drive unit 3c does not have to be carried out even with the variation in the posture of the entire spatial light modulator 3a as long as the variation in the position of the primary light intensity distribution by the reflected light Lr is within a tolerance. In this case, the adverse effect of the diffraction interference fringes on the pupil intensity distribution is reduced even if the variation in the position of the diffraction interference fringes by the diffracted light Ld is small as the variation in the position of the primary light intensity distribution by the reflected light Lr is.

On the other hand, if the variation in the position of the light intensity distribution formed on the illumination pupil by the reflected light Lr on each mirror element SE is over the tolerance, the posture of each mirror element SE needs to be adjusted by the drive unit 3c, according to the variation in the posture of the entire spatial light modulator 3a. In this case, as shown in Fig. 5, the posture of each mirror element SE can be individually adjusted so that the relative angle between the incident light Li and the reflecting surface of each mirror element SE (in turn, the direction of the reflected light Lr from each mirror element SE) can be always kept constant, even with the variation in the posture of the entire spatial light modulator 3a. In other words, only the position of the diffraction interference fringes by the diffracted light Ld can be varied without variation in the position of the primary light intensity distribution by the reflected light Lr, by individually adjusting the posture of each mirror element SE so as to keep the reflecting surface of each mirror element SE at a constant angle to a space axis outside the spatial light modulator 3a, even with variation in the posture of the entire spatial light modulator 3a.

Another applicable method is to perform such adjustment as to switch the posture of each mirror element SE into a required posture for each pulse, with little variation in the light intensity distribution formed on the illumination pupil by the reflected light Lr from each mirror element SE, though the relative angle between the incident light Li and the reflecting surface of each mirror element SE (in turn, the direction of the reflected light Lr from each mirror element SE) is not kept constant. In other words, though the reflecting surface of each mirror element SE is not kept at a constant angle to a space axis outside the spatial light modulator 3a, only the position of the diffraction interference fringes by the diffracted light Ld can be varied by individually adjusting the postures of the respective mirror elements SE for each pulse so as to keep the primary light intensity distribution by the reflected light Lr still.

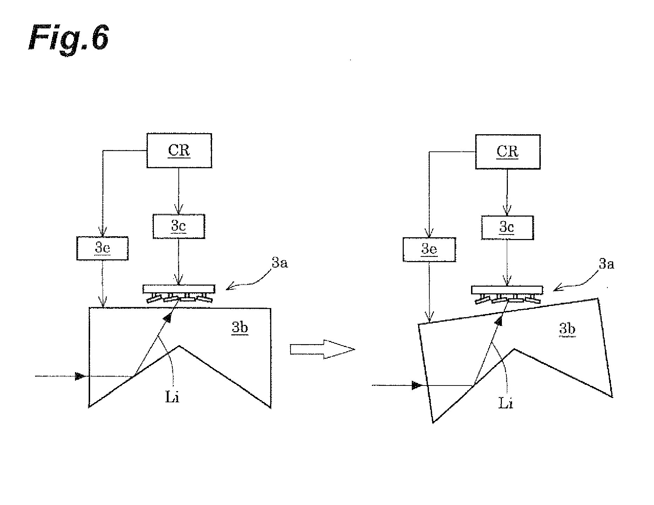

A second method of the present embodiment is, as shown in Fig. 6, to vary a posture of the prism 3b having the reflecting faces and refracting faces, and therefore vary the direction of the incident light Li to the diffracted light generating region according to the lapse of time, by action of a second varying unit 3e operating in accordance with a control signal from the control unit CR. The second varying unit 3e applicable herein is, for example, a drive device (piezoelectric device or the like) attached to the prism 3b. With variation in the posture of the prism 3b, the direction of the incident light Li to the spatial light modulator 3a varies. On the other hand, the direction of the top surface of the mirror frame FR, the direction of the surface of the base BA, and the direction of the reflecting surface of each mirror element SE do not vary with variation in the posture of the prism 3b.

Therefore, the direction of the diffracted light Ld as unwanted light emerging from the diffracted light generating region of the top surface of the mirror frame FR (or the surface of the base BA) and the direction of the reflected light Lr from each mirror element SE vary with variation in the posture of the prism 3b. As a result, the position of the diffraction interference fringes formed on the illumination pupil by the diffracted light Ld and the position of the light intensity distribution formed on the illumination pupil by the reflected light Lr vary according to the lapse of time.

As long as the variation in the position of the light intensity distribution by the reflected light Lr from each mirror element SE is within the tolerance, there is no need for carrying out adjustment of the posture of each mirror element SE by the drive unit 3c even with variation in the posture of the prism 3b. On the other hand, if the variation in the position of the light intensity distribution formed on the illumination pupil by the reflected light Lr on each mirror element SE is over the tolerance, it is necessary to individually adjust the postures of the respective mirror elements SE by the drive unit 3c, according to the variation in the posture of the prism 3b. In this case, the adjustment of the posture of each mirror element SE is the same as the adjustment in the first technique. The reflecting faces or refracting faces of the prism 3b can be regarded as optical surfaces. In this second method, the prism 3b can be regarded as a light-guiding optical system and the reflecting surfaces of the prism 3b can be regarded as a part of the light-guiding optical system.

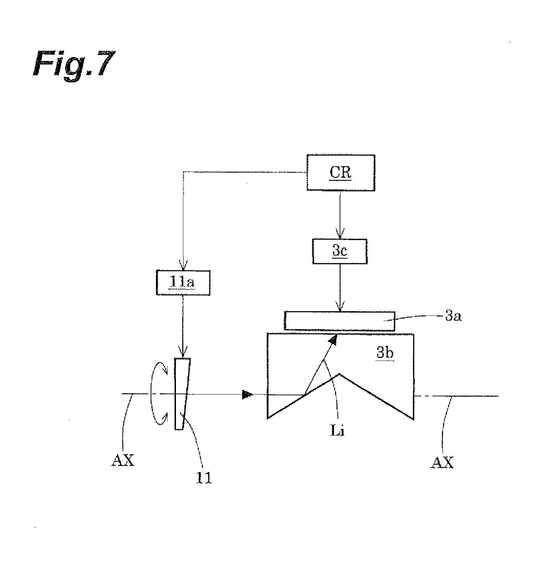

In the above-described second technique, the direction of the incident light Li to the diffracted light generating region is changed by varying the posture of the prism 3b. However, without having to be limited to this, the direction of the incident light Li to the diffracted light generating region can also be varied by changing the direction of the light incident to the prism 3b, for example, as in a third technique shown in Fig. 7. Specifically, the third technique of the present embodiment is, for example, to rotate an angle-deviating prism 11 arranged on the entrance side of the prism 3b and having two planes (refracting surfaces) intersecting at a predetermined angle, around the optical axis AX by action of a third varying unit 11a operating in accordance with a control signal from the control unit CR. The refracting surfaces of this angle-deviating prism 11 can be regarded as optical surfaces. In this third technique, the angle-deviating prism 11 can be regarded as a part of the light-guiding optical system.

In this manner, by action of the angle-deviating prism 11 rotating around the optical axis AX, the direction of the light incident to the prism 3b and therefore the direction of the incident light Li to the diffracted light generating region vary according to the lapse of time. Fig. 7 illustrates the angle-deviating prism 11 rotating around the optical axis AX, as a means for varying the direction of the light incident to the prism 3b, but the direction of the light incident to the prism 3b can also be varied, for example, by vibrating a plane mirror for bending of optical path arranged in front of the prism 3b.

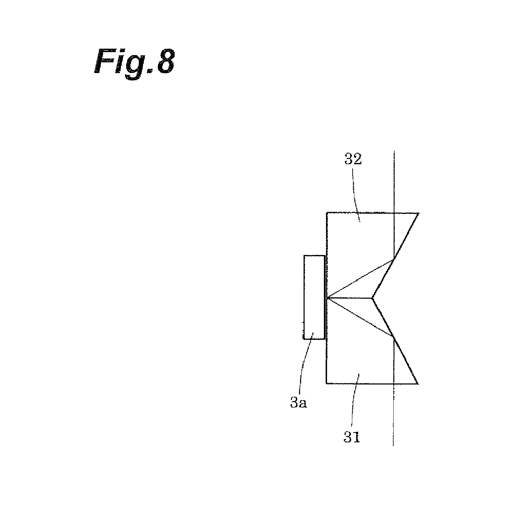

In the above description, the K prism 3b integrally formed of a single optical block is used as the prism member having the optical surface opposed to the plane where the plurality of mirror elements of the spatial light modulator 3a are arrayed. However, without having to be limited to this, it is also possible to adopt a configuration wherein a prism member having the same function as the K prism 3b is composed of a pair of prisms 31 and 32, for example, as shown in Fig. 8. In this case, light passes through contact surfaces of the prisms 31 and 32 and it is thus necessary to polish the contact surfaces. In some cases, it is necessary to achieve optical contact between the prisms 31 and 32.

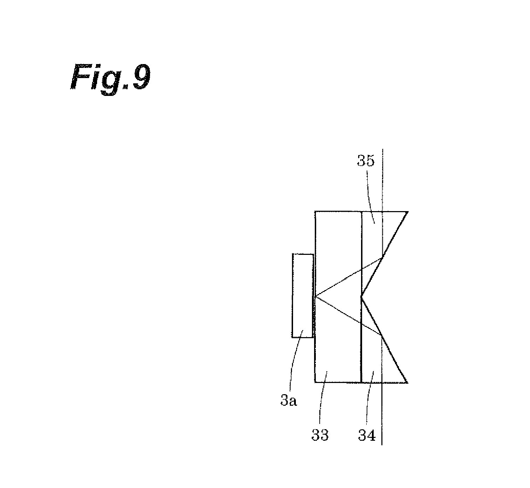

Furthermore, a prism member having the same function as the K prism 3b can also be constructed, for example, by a plane-parallel plate 33 and a pair of triangular prisms 34 and 35 as shown in Fig. 9. Since the triangular prisms 34 and 35 are not in contact with each other, there is no need for optical contact between the triangular prisms 34 and 35. The plane-parallel plate 33 and the triangular prisms 34, 35 may be arranged in contact with each other or may be arranged with a space between them. Since the plane-parallel plate 33 also serves as a cover glass for the spatial light modulator 3a, the triangular prisms 34 and 35 do not have to be replaced while the plane-parallel plate 33 and the spatial light modulator 3a are replaced, in replacement after a lapse of a lifetime of the spatial light modulator 3a.

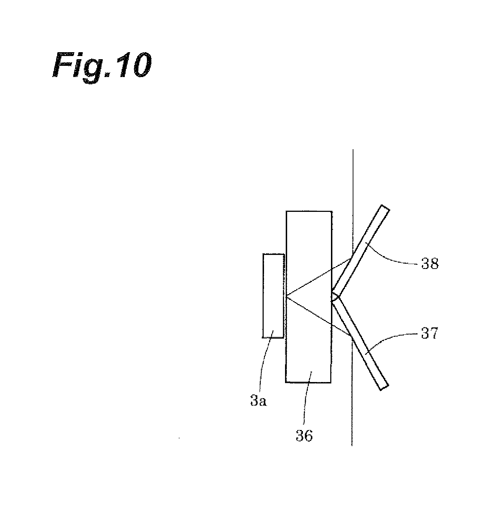

It is also possible to construct an assembled optical member having the same function as the K prism 3b, for example, by a plane-parallel plate 36 and a pair of plane mirrors 37 and 38, for example, as shown in Fig. 10. The configuration shown in Fig. 10 is obtained by replacing the triangular prisms 34 and 35 in Fig. 9 with the plane mirrors 37 and 38. In this case, just as in the case of the configuration example of Fig. 9, there is no need for replacement of the plane mirrors 37 and 38 with need for replacement of the plane-parallel plate 36 and the spatial light modulator 3a in replacement after the lapse of the lifetime of the spatial light modulator 3a. Furthermore, the angle of the light incident to the spatial light modulator 3a can be made smaller by the degree of refraction of the light incident from the plane mirror 37 into the plane-parallel plate 36 than that in the configuration example of Fig. 9.

For applying the aforementioned second technique to this configuration example of Fig. 10, it is sufficient to vary the posture of the plane mirror 37 located on the entrance side of the spatial light modulator 3a. It is also possible to adopt a configuration for integrally varying the postures of the plane mirrors 37 and 38. The reflecting surfaces of these plane mirrors 37 and 38 can be regarded as optical surfaces. This plane mirror 37 can be regarded as a part of the light-guiding optical system.

In the above description, the spatial light modulator in which the orientations (angles: inclinations) of the reflecting surfaces arrayed two-dimensionally can be individually controlled is used as the spatial light modulator having the plurality of optical elements arrayed two-dimensionally and controlled individually. However, without having to be limited to this, it is also possible, for example, to apply a spatial light modulator in which heights (positions) of the reflecting surfaces arrayed two-dimensionally can be individually controlled. Such a spatial light modulator applicable herein can be selected, for example, from those disclosed in Japanese Patent Application Laid-open No. 6-281869 and U.S. Pat. No. 5,312,513 corresponding thereto, and in Fig.1d of Published Japanese Translation of PCT Application No. 2004-520618 and U.S. Pat. No. 6,885,493 corresponding thereto. These spatial light modulators are able to apply the same action as a diffracting surface, to incident light by forming a two-dimensional height distribution. The aforementioned spatial light modulator having the plurality of reflecting surfaces arrayed two-dimensionally may be modified, for example, according to the disclosure in Published Japanese Translation of PCT Application No. 2006-513442 and U.S. Pat. No. 6,891,655 corresponding thereto, or according to the disclosure in Published Japanese Translation of PCT Application No. 2005-524112 and U.S. Pat. Published Application No. 2005/0095749 corresponding thereto.

In the above description, the spatial light modulator applied is the reflection type spatial light modulator having the plurality of mirror elements, but, without having to be limited to this, it is also possible, for example, to apply the transmission type spatial light modulator disclosed in U.S. Pat. No. 5,229,872. The teachings of U.S. Pat. Nos. 5,312,513, 6,885,493, and 6,891,655, U.S. Pat. Published Application No. 2005/0095749, and U.S. Pat. No. 5,229,872 are incorporated herein by reference.

In the above-described embodiment, the optical system may be modified so that in the formation of the pupil intensity distribution using the spatial light modulating unit, the pupil intensity distribution is measured with a pupil luminance distribution measuring device and the spatial light modulator in the spatial light modulating unit is controlled according to the result of the measurement. Such technology is disclosed, for example, in Japanese Patent Application Laid-open No. 2006-54328 and in Japanese Patent Application Laid-open No. 2003-22967 and U.S. Pat. Published Application No. 2003/0038225 corresponding thereto. The teachings of U.S. Pat. Published Application No. 2003/0038225 are incorporated herein by reference.

In the aforementioned embodiment, the mask can be replaced with a variable pattern forming device which forms a predetermined pattern on the basis of predetermined electronic data. Use of such a variable pattern forming device can minimize influence on synchronization accuracy even if the pattern surface is set vertical. The variable pattern forming device applicable herein can be, for example, a DMD (Digital Micromirror Device) including a plurality of reflective elements driven based on predetermined electronic data. The exposure apparatus with the DMD is disclosed, for example, in Japanese Patent Application Laid-open No. 2004-304135, International Publication WO2006/080285, and U.S. Pat. Published Application No. 2007/0296936 corresponding thereto. Besides the reflective spatial light modulators of the non-emission type like the DMD, it is also possible to apply a transmission type spatial light modulator or a self-emission type image display device. It is noted that the variable pattern forming device can also be used in cases where the pattern surface is set horizontal. The teachings of U.S. Pat. Published Application No. 2007/0296936 are incorporated herein by reference.

In the foregoing embodiment, the fly's eye lens 5 was used as an optical integrator, but an optical integrator of an internal reflection type (typically, a rod type integrator) may be used instead thereof. In this case, a condenser lens is arranged behind the zoom optical system 4 so that its front focus position coincides with the rear focus position of the zoom optical system 4, and the rod type integrator is arranged so that an entrance end thereof is positioned at or near the rear focus position of the condenser lens. At this time, an exit end of the rod type integrator is at the position of the illumination field stop 7. In the use of the rod type integrator, a position optically conjugate with the position of the aperture stop AS of the projection optical system PL, in the field stop imaging optical system 8 downstream the rod type integrator can be called an illumination pupil plane. Since a virtual image of the secondary light source on the illumination pupil plane is formed at the position of the entrance plane of the rod type integrator, this position and positions optically conjugate therewith can also be called illumination pupil planes. The zoom optical system 4 and the foregoing condenser lens can be regarded as a condensing optical system arranged in the optical path between the optical integrator and the spatial light modulator, and the zoom optical system 4, the foregoing condenser lens, and the rod type integrator can be regarded as a distribution forming optical system.

The exposure apparatus of the foregoing embodiment is manufactured by assembling various sub-systems containing their respective components as set forth in the scope of claims in the present application, so as to maintain predetermined mechanical accuracy, electrical accuracy, and optical accuracy. For ensuring these various accuracies, the following adjustments are carried out before and after the assembling: adjustment for achieving the optical accuracy for various optical systems; adjustment for achieving the mechanical accuracy for various mechanical systems; adjustment for achieving the electrical accuracy for various electrical systems. The assembling steps from the various sub-systems into the exposure apparatus include mechanical connections, wire connections of electric circuits, pipe connections of pneumatic circuits, etc. between the various sub-systems. It is needless to mention that there are assembling steps of the individual sub-systems, before the assembling steps from the various sub-systems into the exposure apparatus. After completion of the assembling steps from the various sub-systems into the exposure apparatus, overall adjustment is carried out to ensure various accuracies as the entire exposure apparatus. The manufacture of the exposure apparatus may be performed in a clean room in which the temperature, cleanliness, etc. are controlled.

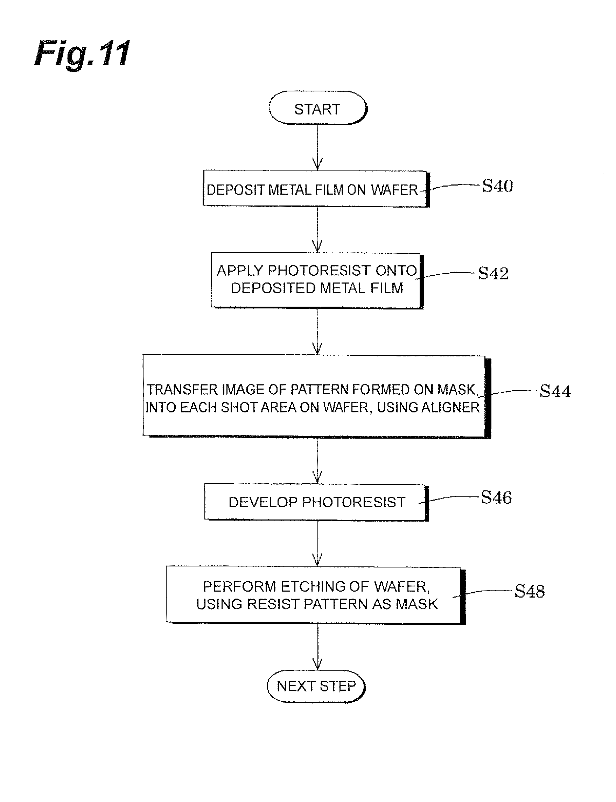

The following will describe a device manufacturing method using the exposure apparatus according to the above-described embodiment. Fig. 11 is a flowchart showing manufacturing steps of semiconductor devices. As shown in Fig. 11, the manufacturing steps of semiconductor devices include depositing a metal film on a wafer W to become a substrate of semiconductor devices (step S40) and applying a photoresist as a photosensitive material onto the deposited metal film (step S42). The subsequent steps include transferring a pattern formed on a mask (reticle) M, into each shot area on the wafer W, using the projection exposure apparatus of the above embodiment (step S44: exposure step), and developing the wafer W after completion of the transfer, i.e., developing the photoresist on which the pattern is transferred (step S46: development step). Thereafter, using the resist pattern made on the surface of the wafer W in step S46, as a mask, processing such as etching is carried out on the surface of the wafer W (step S48: processing step).

The resist pattern herein is a photoresist layer in which depressions and projections are formed in a shape corresponding to the pattern transferred by the projection exposure apparatus of the above embodiment and which the depressions penetrate throughout. Step S48 is to process the surface of the wafer W through this resist pattern. The processing carried out in step S48 includes, for example, at least either etching of the surface of the wafer W or deposition of a metal film or the like. In step S44, the projection exposure apparatus of the above embodiment performs the transfer of the pattern onto the wafer W coated with the photoresist, as a photosensitive substrate or plate P.

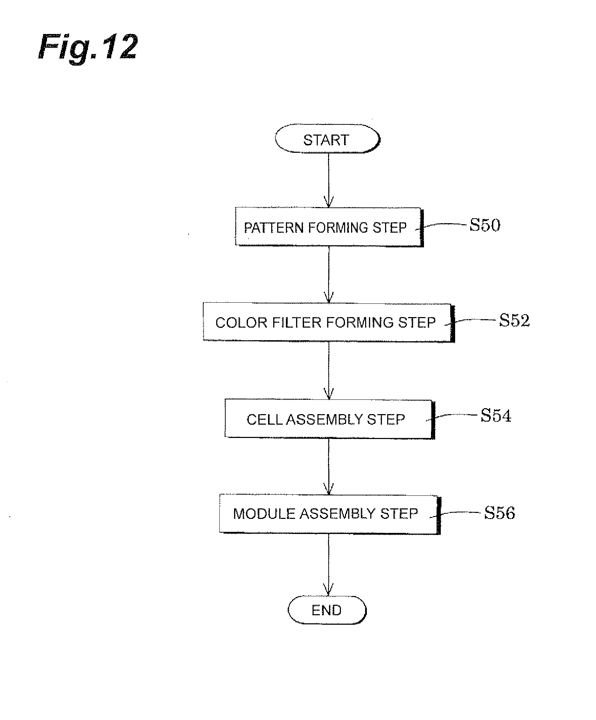

Fig. 12 is a flowchart showing manufacturing steps of a liquid crystal device such as a liquid crystal display device. As shown in Fig. 12, the manufacturing steps of the liquid crystal device include sequentially performing a pattern forming step (step S50), a color filter forming step (step S52), a cell assembly step (step S54), and a module assembly step (step S56).

The pattern forming step of step S50 is to form predetermined patterns such as a circuit pattern and an electrode pattern on a glass substrate coated with a photoresist, as a plate P, using the aforementioned projection exposure apparatus of the above embodiment. This pattern forming step includes an exposure step of transferring a pattern to a photoresist layer, using the projection exposure apparatus of the above embodiment, a development step of performing development of the plate P on which the pattern is transferred, i.e., development of the photoresist layer on the glass substrate, to form the photoresist layer in the shape corresponding to the pattern, and a processing step of processing the surface of the glass substrate through the developed photoresist layer.

The color filter forming step of step S52 is to form a color filter in which a large number of sets of three dots corresponding to R (Red), G (Green), and B (Blue) are arrayed in a matrix pattern, or in which a plurality of filter sets of three stripes of R, G, and B are arrayed in a horizontal scan direction.

The cell assembly step of step S54 is to assemble a liquid crystal panel (liquid crystal cell), using the glass substrate on which the predetermined pattern has been formed in step S50, and the color filter formed in step S52. Specifically, for example, a liquid crystal is poured into between the glass substrate and the color filter to form the liquid crystal panel. The module assembly step of step S56 is to attach various components such as electric circuits and backlights for display operation of this liquid crystal panel, to the liquid crystal panel assembled in step S54.

The present invention is not limited just to the application to the exposure apparatuss for manufacture of semiconductor devices, but can also be widely applied, for example, to the exposure apparatuss for the liquid crystal display devices formed with rectangular glass plates, or for display devices such as plasma displays, and to the exposure apparatuss for manufacture of various devices such as imaging devices (CCDs and others), micro machines, thin film magnetic heads, and DNA chips. Furthermore, the present invention is also applicable to the exposure step (exposure apparatus) for manufacture of masks (photomasks, reticles, etc.) on which mask patterns of various devices are formed, by the photolithography process.

The above-described embodiment can use the ArF excimer laser light (wavelength: 193 nm) or the KrF excimer laser light (wavelength: 248 nm) as the exposure light. Furthermore, without having to be limited to this, the present invention can also use any other appropriate laser light source, e.g., an $F_2$ laser light source which supplies laser light at the wavelength of 157 nm.

In the foregoing embodiment, it is also possible to apply a technique of filling the interior of the optical path between the projection optical system and the photosensitive substrate with a medium having the refractive index larger than 1.1 (typically, a liquid), which is so called a liquid immersion method. In this case, it is possible to adopt one of the following techniques as a technique of filling the interior of the optical path between the projection optical system and the photosensitive substrate with the liquid: the technique of locally filling the optical path with the liquid as disclosed in International Publication WO99/49504; the technique of moving a stage holding the substrate to be exposed, in a liquid bath as disclosed in Japanese Patent Application Laid-open No. 6-124873; the technique of forming a liquid bath of a predetermined depth on a stage and holding the substrate therein as disclosed in Japanese Patent Application Laid-open No. 10-303114, and so on. The teachings of International Publication WO99/49504, Japanese Patent Application Laid-open No. 6-124873, and Japanese Patent Application Laid-open No. 10-303114 are incorporated herein by reference.

In the above embodiment, it is also possible to apply the so-called polarization illumination methods as disclosed in U.S. Pat. Published Application Nos. 2006/0170901 and 2007/0146676. The teachings of U.S. Pat. Published Application Nos. 2006/0170901 and 2007/0146676 are incorporated herein by reference.

The foregoing embodiment was the application of the present invention to the illumination optical system for illuminating the mask in the exposure apparatus, but, without having to be limited to this, the present invention can also be applied to commonly-used illumination optical systems for illuminating an illumination target surface except for the mask.

**Claims**

1. A spatial light modulating unit comprising:

    a spatial light modulator having a plurality of optical elements arrayed two-dimensionally and controlled individually; and
    angle varying means which varies a relative angle between a diffracted light generating region to generate diffracted light around each of the plurality of optical elements, and incident light to the diffracted light generating region.

2. The spatial light modulating unit according to claim 1, wherein the angle varying means has first varying means which varies a posture of the diffracted light generating region.

3. The spatial light modulating unit according to claim 1 or 2, wherein the angle varying means has second varying means which varies a direction of the incident light to the diffracted light generating region.

4. The spatial light modulating unit according to any one of claims 1 to 3, wherein the spatial light modulator has a plurality of mirror elements arrayed two-dimensionally, and a drive unit which individually controls and drives postures of the plurality of mirror elements.

5. The spatial light modulating unit according to claim 4, wherein the drive unit continuously varies orientations of the plurality of mirror elements.

6. The spatial light modulating unit according to claim 4 or 5, further comprising a control unit which controls the drive unit in order to vary the postures of the plurality of mirror elements according to variation in the relative angle by the angle varying means.

7. The spatial light modulating unit according to any one of claims 4 to 6, further comprising an optical surface provided on the light entrance side of the plurality of mirror elements.

8. The spatial light modulating unit according to claim 7, wherein the second varying means varies a posture of the optical surface.

9. The spatial light modulating unit according to claim 7 or 8, wherein the second varying means varies a direction of light incident to the optical surface.

10. The spatial light modulating unit according to any one of claims 7 to 9, wherein the optical surface comprises a reflecting surface or a refracting surface.

11. The spatial light modulating unit according to any one of claims 7 to 10, further comprising a prism member having the optical surface.

12. The spatial light modulating unit according to any one of claims 4 to 6, further comprising a prism member having an optical surface opposed to a plane where the plurality of mirror elements are arrayed.

13. The spatial light modulating unit according to claim 12, wherein the second varying means varies a posture of the prism member.

14. The spatial light modulating unit according to claim 12 or 13, wherein the second varying means varies a direction of light incident to the prism member.

15. An illumination optical system which illuminates an illumination target surface on the basis of light from a light source, said illumination optical system comprising:

the spatial light modulating unit as set forth in any one of claims 1 to 14; and
a distribution forming optical system which forms a predetermined light intensity distribution on an illumination pupil of the illumination optical system, based on a flux of light having traveled via the spatial light modulator.

16. An illumination optical system which illuminates an illumination target surface on the basis of light from a light source, said illumination optical system comprising:

a spatial light modulator having a plurality of optical elements arrayed two-dimensionally and controlled individually, and a diffracted light generating region which generates diffracted light around each of the plurality of optical elements; and
a light-guiding optical system which guides the light from the light source to the spatial light modulator,
wherein a posture of at least one of the spatial light modulator and at least a part of the light-guiding optical system is variable in order to vary a relative angle between the diffracted light generating region and incident light to the diffracted light generating region.

**17.** The illumination optical system according to claim 15 or 16, wherein the distribution forming optical system has an optical integrator, and a condensing optical system arranged in an optical path between the optical integrator and the spatial light modulating unit.

**18.** The illumination optical system according to any one of claims 15 to 17, wherein the plurality of optical elements are controlled so as to keep the predetermined light intensity distribution still on the illumination pupil with variation in the relative angle by the angle varying means.

**19.** The illumination optical system according to any one of claims 15 to 18, which is used in combination with a projection optical system for forming a plane optically conjugate with the illumination target surface, wherein the illumination pupil is a position optically conjugate with an aperture stop of the projection optical system.

**20.** An exposure apparatus comprising the illumination optical system as set forth in any one of claims 15 to 19 for illuminating a predetermined pattern, wherein the predetermined pattern is transferred onto a photosensitive substrate to effect exposure thereof.

**21.** A device manufacturing method comprising:

an exposure step of transferring the predetermined pattern onto the photosensitive substrate to effect exposure thereof, using the exposure apparatus as set forth in claim 20;
a development step of developing the photosensitive substrate on which the predetermined pattern is transferred, to form a mask layer of a shape corresponding to the predetermined pattern, on a surface of the photosensitive substrate; and
a processing step of processing the surface of the photosensitive substrate through the mask layer.

**Fig.1**

# *Fig.2*

# Fig.3

# Fig.4

# Fig.5

## Fig.6

*Fig.7*

# Fig.8

*Fig.9*

# Fig.10

# Fig.11

```
        ┌─────────┐
        │  START  │
        └─────────┘
             │
             ▼
  ┌──────────────────────────┐
  │ DEPOSIT METAL FILM ON WAFER │────── S40
  └──────────────────────────┘
             │
             ▼
  ┌──────────────────────────┐
  │ APPLY PHOTORESIST ONTO   │────── S42
  │ DEPOSITED METAL FILM     │
  └──────────────────────────┘
             │
             ▼
  ┌─────────────────────────────────────────┐
  │ TRANSFER IMAGE OF PATTERN FORMED ON MASK, │────── S44
  │ INTO EACH SHOT AREA ON WAFER, USING ALIGNER│
  └─────────────────────────────────────────┘
             │
             ▼
  ┌──────────────────────────┐
  │ DEVELOP PHOTORESIST      │────── S46
  └──────────────────────────┘
             │
             ▼
  ┌──────────────────────────┐
  │ PERFORM ETCHING OF WAFER, │────── S48
  │ USING RESIST PATTERN AS MASK│
  └──────────────────────────┘
             │
             ▼
        ┌───────────┐
        │ NEXT STEP │
        └───────────┘
```

# Fig.12

```
              ┌─────────────┐
              │    START    │
              └──────┬──────┘
                     │
                     ▼
        ┌───────────────────────────┐
        │   PATTERN FORMING STEP    │──── S50
        └─────────────┬─────────────┘
                      │
                      ▼
       ┌─────────────────────────────┐
       │  COLOR FILTER FORMING STEP  │──── S52
       └──────────────┬──────────────┘
                      │
                      ▼
        ┌───────────────────────────┐
        │     CELL ASSEMBLY STEP    │──── S54
        └─────────────┬─────────────┘
                      │
                      ▼
        ┌───────────────────────────┐
        │    MODULE ASSEMBLY STEP   │──── S56
        └─────────────┬─────────────┘
                      │
                      ▼
              ┌─────────────┐
              │     END     │
              └─────────────┘
```

## INTERNATIONAL SEARCH REPORT

| | International application No. |
|---|---|
| | PCT/JP2008/069997 |

**A. CLASSIFICATION OF SUBJECT MATTER**
*G02B26/08*(2006.01)i, *G02B19/00*(2006.01)i, *G03F7/20*(2006.01)i, *H01L21/027*
(2006.01)i

According to International Patent Classification (IPC) or to both national classification and IPC

**B. FIELDS SEARCHED**

Minimum documentation searched (classification system followed by classification symbols)
G02B26/00-26/08, G02B5/00-5/136, G02B7/28, G02B9/00-17/08,
G02B21/02-21/04, G02B25/00-25/04, G03F7/20-7/24, G03F9/00-9/02,
H01L21/027

Documentation searched other than minimum documentation to the extent that such documents are included in the fields searched
    Jitsuyo Shinan Koho      1922-1996   Jitsuyo Shinan Toroku Koho   1996-2008
    Kokai Jitsuyo Shinan Koho   1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-136387 A (ASML Netherlands B.V.),<br>26 May, 2005 (26.05.05),<br>Claims 1, 7; Par. Nos. [0041] to [0047], [0050]<br>to [0052]; Figs. 1, 5, 7, 8<br>& US 2005/0074906 A1   & US 2005/0068510 A1<br>& EP 1517188 A2 | 1-21 |
| Y | JP 2007-258691 A (Semiconductor Energy<br>Laboratory Co., Ltd.),<br>04 October, 2007 (04.10.07),<br>Par. No. [0006]<br>& US 2007/0195834 A1 | 1-21 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 November, 2008 (27.11.08) | 09 December, 2008 (09.12.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/069997

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 5-102003 A (Nikon Corp.), 23 April, 1993 (23.04.93), Par. Nos. [0029] to [0035]; Figs. 1, 3 & US 5719704 A          & US 6100961 A & US 2002/0048008 A1 | 7-14 |
| Y | JP 2001-350105 A (Kabushiki Kaisha Oyo Koden Kenkyushitsu), 21 December, 2001 (21.12.01), Par. Nos. [0021], [0031], [0032]; Figs. 3, 4 (Family: none) | 7-14 |
| Y | JP 2002-353105 A (Nikon Corp.), 06 December, 2002 (06.12.02), Par. Nos. [0003], [0017] to [0023], [0027] to [0031]; Figs. 1 to 4, 6, 7 (Family: none) | 15-21 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002353105 A
- US 6913373 B
- US 6741394 B
- JP 10503300 W
- JP 779530 A
- JP 2004078136 A
- US 6900915 B
- JP 2006524349 W
- US 7095546 B
- JP 2006113437 A
- EP 779530 A
- JP 6281869 A
- US 5312513 A
- JP 2004520618 W
- US 6885493 B
- JP 2006513442 W
- US 6891655 B
- JP 2005524112 W
- US 20050095749 A
- US 5229872 A
- JP 2006054328 A
- JP 2003022967 A
- US 20030038225 A
- JP 2004304135 A
- WO 2006080285 A
- US 20070296936 A
- WO 9949504 A
- JP 6124873 A
- JP 10303114 A
- US 20060170901 A
- US 20070146676 A